# EUROPEAN PATENT APPLICATION

(11) **EP 4 372 776 A1**
(43) Date of publication of application: **22.05.2024**
(21) Application number: 23000159.6
(22) Date of filing: 15.11.2023
(51) Int. Cl.: H01H 9/04, H01H 21/08, H01H 23/06, H01H 13/06

(54) **CASING FOR SWITCHES FOR INDUSTRIAL MACHINE OR PLANT CONTROL AND SWITCH COMPRISING THE CASING**

(30) Priority: 16.11.2022 IT 202200023664
(71) Applicant: Pizzato Elettrica S.r.l., 36063 Marostica (Vicenza) (IT)
(72) Inventor: Pizzato, Marco, 36063 Marostica (VI) (IT); Zonta, Simone, 36061 Bassano del Grappa (VI) (IT)
(74) Representative: Dalla Rosa, Silvia

(57) **Abstract**

A casing for switches for industrial machine or plant control comprises a containment shell (**2**) having at least one opening (**4**) made on its front face (**5**) for accessing thereinside and having an outer perimeter edge (**8**), a lid (**6**) anchored in a movable manner to the front face (**5**) and having a perimeter edge (**7**) adapted to at least partially overlap the outer perimeter edge (**8**). The lid (**6**) has on its inner face a groove (**9**) which extends along the whole perimeter edge (**7**) thereof, internally thereto and which has a gasket (**10**). The front face (**5**) has a raised sealing edge (**11**) which extends internally to the outer perimeter edge (**8**) and along the whole longitudinal extension of said outer perimeter edge (**8**), said raised sealing edge (**11**) having a profile corresponding to that of said groove (**9**).

## Description

### Technical field

The present invention finds application in the technical filed of electrical devices for industrial use and particularly relates with a casing suitable to be used for the assembly of switches for the control of industrial machines or plants, such as proximity switches and safety switches for the control of access to barriers or safety perimeters for industrial machines and plants.

The invention also relates with the above switch for the control of industrial machines or plants which comprises the casing.

### State of the art

As known, switches for controlling industrial machines and plants are generally provided with a casing designed to be mounted on a fixed or movable part of the machine or plant.

For example, with proximity switches, i.e. devices designed to detect the movement of one or more parts of the machine or plant which it is associated to, the casing is designed to be anchored to a frame or panel of the machine or plant and is associated to a drive head which intercepts, by operating the movable element thereof, the mechanical movement that has to be detected.

Furthermore, the casing houses thereinside proper electrical switching means suitable to be operated by the movement of the switch head and whose configuration may vary depending on the specific switch.

A further kind of switches is represented by safety switches for the protection of barrier accesses and safety perimeters for industrial machines or plants, which generally comprise a switching device suitable to be anchored to the fixed part of the access and an actuator device suitable to be anchored to the movable part.

The switching device in turn comprises a casing designed to house the switching means, whose configuration may vary depending on the specific switch, as well as to allow the wiring of the switching means and the application of one or more additional auxiliary modules.

Typically, regardless of the type of switches for which it is designed for, the casing is provided with an opening lid which makes it possible to access the components contained inside.

Generally, the opening lid is placed frontally on the main body of the casing and fixed to it by one or more screws.

The materials and other features of the casing, such as watertightness and resistance to dust entry, vary depending on the intended use of the switch for which the casing is designed.

In particular, plastic materials are usually used with casing designed for assembly cheaper switches.

The use of such materials entails some drawbacks which reduce their performance and limit their field of application, not making them suitable for use in particularly humid environments or with the presence of water.

These drawbacks are increased in those applications wherein a limitation of the transversal dimensions of the switch is required and which ask for the use of relatively thin casings.

As matter of fact, with thin casings made of plastic material are limited by the fact that fixing the lid using fixing screws placed at the edge leads to a deformation of the lid itself, which reduces its sealing features.

Furthermore, the use of a thin cover for reasons of space involves the use of gaskets which are also of reduced height, with the consequence that the switch will have an IP degree of protection against the entry of liquids, according to the EN 60529 standard, relatively low.

EP 1039578 discloses a switch that comprise a casing having an opening for the insertion of a conductive cable and an open face suitable for being closed by a lid hinged to the casing. The lid has a groove that houses a gasket which is engaged by the shaped outer edge of the casing. However, the outer edge of the casing has a tapered profile which does not extend across the entire perimeter of the casing and which does not allow it to press entirely on the gasket, so that the casing does not have a degree of protection against the entry of dust and liquids sufficiently high for use in particularly dirty or humid environments.

GB2346483 discloses a casing for electrical elements of the water-proof type which has a housing that is resealable by lid slightly oversized compared to the size of the housing and that is provide with a gasket with a U-shaped section into which the outermost edge of the casing fits.

Also in this case, the shape of the edge does not allow for an interaction between the edge and the gasket sufficient to allow a sufficiently high degree of protection against the entry of liquids.

### Scope of the invention

The object of the present invention is to overcome the above-mentioned drawbacks by providing a casing for switches for the control of industrial machines or plants, in particular proximity switches or safety switches for the control of accesses for industrial machines and plants, which has properties of high efficiency and relative cost-effectiveness.

A particular object is to provide a casing for switches for the control of industrial machines or plants which, while maintaining cost-effective features by making it of plastic material and with relatively small overall dimensions, guarantees significantly high hermeticity and resistance against the entry of dust and liquids, for use even in particularly dusty and/or humid environments.

Yet another particular object is to provide the above casing for safety switches for access control which combines its properties of relative cost-effectiveness with high robustness.

These objects, as well as others which will become more apparent hereinafter, are achieved by a casing for switches for the control of industrial machines and plants which, according to claim 1, comprises a containment shell having at least one opening made on its front face for accessing thereinside and having an outer perimeter edge, a lid anchored in a movable manner to said front face provided with said opening and having a perimeter edge adapted to at least partially overlap the outer perimeter edge of said opening, wherein said lid has on its inner face a groove which extends along its perimeter edge, internally thereto, a gasket housed in said groove being also provided.

The open front face of the shell has a raised sealing edge that develops internally to the perimeter edge of the opening and along the whole development of the same perimeter edge, with a profile corresponding to that of said groove.

The raised sealing edge that extends along the entire length of the outer perimeter edge will allow for increased sealing against dust and liquids, even when using plastic materials.

The presence of the raised sealing edge placed internally with respect to the outermost edge of the shell will allow for an annular seal, i.e. a seal which extends along the whole perimeter of the lid and which will be in contact with the sealing edge throughout its whole length.

Conveniently, the lid may be hinged on the open face at one side of said perimeter edge, in particular on the lower side, possibly by a hinge for anchoring said lid.

In this way, it will be possible to use the hinged anchoring of the lid, which is more convenient and safe and which allows the upper fixing of the lid using a single central anchoring screw, which will reduce the deformations of the plastic lid caused by the traction of the screw, also representing a cheaper and faster type of anchoring during installation of the switch.

In a particularly advantageous manner, the sealing edge may have a maximum height of a constant value along its whole development and with a value greater than double, for example in a ratio between 5:1 and 3:1, compared to the value of its thickness.

In this way, it will be possible to have a sealing edge, and consequently a lid, with a higher height than the common lids of the casing designed for safety switches for access control already on the market.

It follows that the lid will be more robust and resistant to those stresses that may cause deformation, such as those produced by the fixing screw.

Furthermore, the presence of a higher lid will allow for a deeper groove and a gasket which, consequently, may be made of thicker rubber than common gaskets, and therefore also softer.

Furthermore, the gasket may deform mainly by compression in the same direction of development in height of the sealing edge and not radially thereto, as it is thicker, allowing a better seal against both dust and humidity, allowing to obtain a suitable case to the creation of safety switches resistant to high pressure jets and dust as defined by the IP69K protection degree according to ISO 20653.

According to a further feature, a switch is provided for the control of industrial machines or plants, such as a proximity switch or a safety switch for access control, which, according to claim 13, comprises a switching device provided with the casing according to the present invention.

Advantageous embodiments of the invention are obtained in accordance with the dependent claims.

### Brief disclosure of the drawings

Further features and advantages of the invention will be more apparent in light of the detailed description of some preferred but not exclusive embodiments of a casing, illustrated by way of non-limiting example with the aid of the attached drawing tables wherein:
**FIG. 1** is a perspective view of a switch provided with a casing according to the invention in a first embodiment and in a closed lid condition;
**FIG. 2** is a perspective view of the casing of Fig. 1 in the open lid condition;
**FIG. 3** is a side view of the casing of Fig. 1;
**FIG. 4** is a side view of the casing of Fig. 1 without the lid;
**FIG. 5** is a sectional view of the casing of Fig. 1 according to the trace plane A_A of Fig. 3;
**FIG. 6** is an enlarged view of a detail of Fig. 5;
**FIG. 7** is a perspective view of the casing in a second embodiment and in the closed lid condition;
**FIG. 8** is a perspective view of the casing of Fig. 7 in the open lid condition;
**FIG. 9** is a side view of the casing of Fig. 7;
**FIG. 10** is a side view of the casing of Fig. 7 without the lid;
**FIG. 11** is an enlarged view of a detail of Fig. 10;
**FIG. 12** is a sectional side view of the casing of Fig. 7;
**FIG. 13** is an enlarged view of a detail of Fig. 12;
**FIG. 14** is a sectional view of the casing of Fig. 7 along the trace B_B of Fig. 9;
**FIG. 15** is an enlarged view of a detail of Fig. 14;

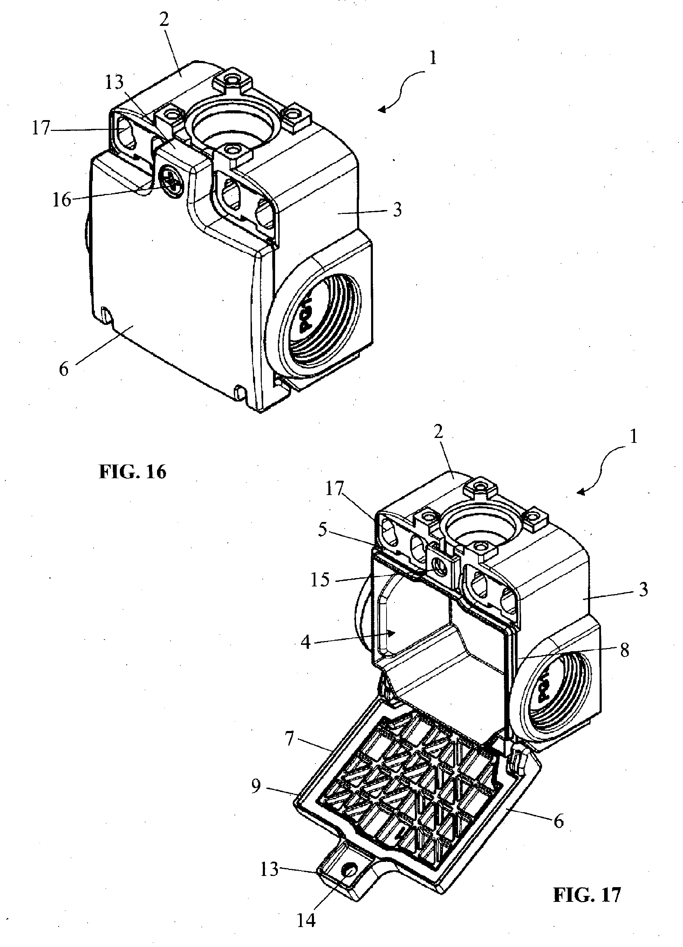

**FIG. 16** is a perspective view of the casing in a third embodiment and in the closed lid condition;
**FIG. 17** is a perspective view of the casing of Fig. 16 in the open lid condition;

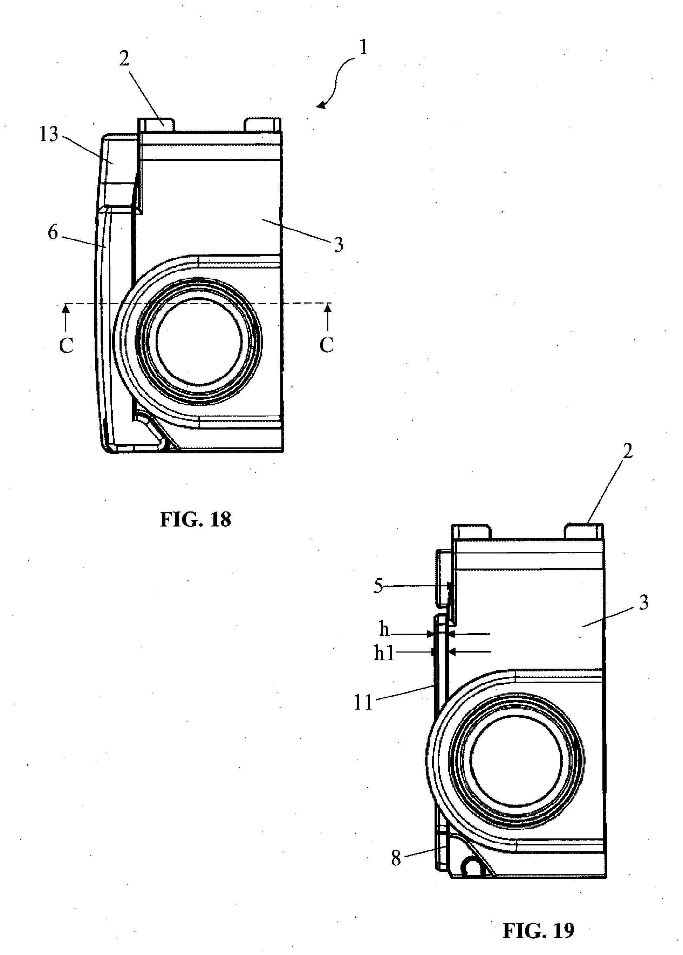

**FIG. 18** is a side view of the casing of Fig. 16;
**FIG. 19** is a side view of the casing of Fig. 16 without lid;

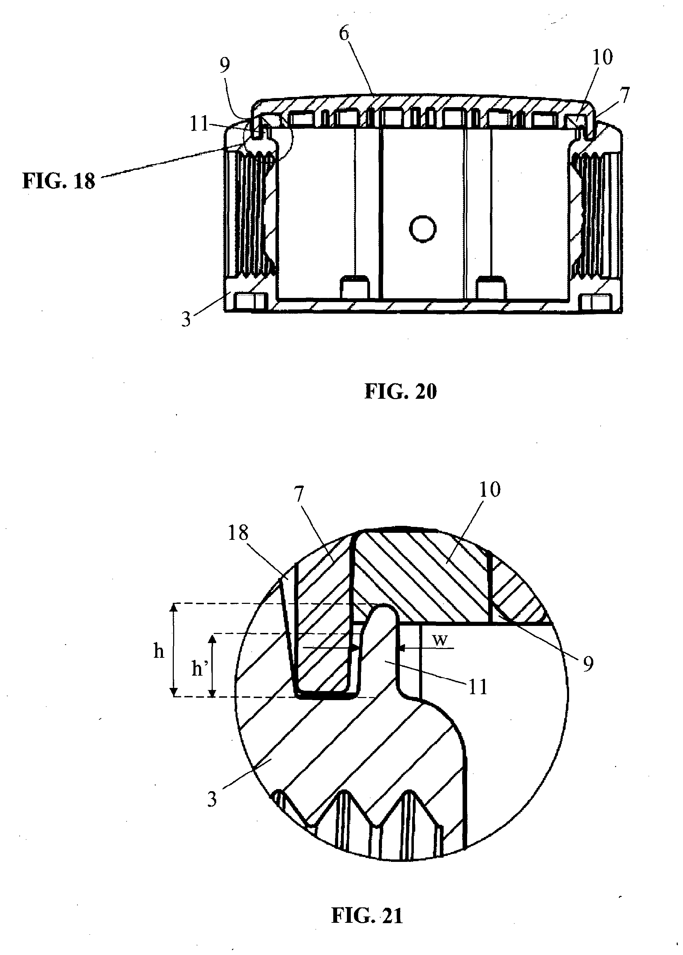

**FIG. 20** is a sectional view of the casing of Fig. 16 along the trace C_C of Fig. 18;
**FIG. 21** is an enlarged view of a detail of Fig. 20.

### Best mode of carrying out the invention

With reference to the attached figures, some preferred but not exclusive embodiments of a casing designed for switch for the control of industrial machines and plants are shown.

In particular, the illustrated casing is designed for a proximity switch suitable for detecting mechanical movements in industrial machine and plants.

in general, the proximity switch, not shown in its entirety as it could be any proximity switch of a known type, will be designed to be mounted or in any case positioned, preferably but not exclusively, on a frame or panel of the machine to be controlled at the mechanical movements to be detected.

In an also known manner, the main object of the proximity switch will be that of signalling the mechanical movement that has occurred, which may be any movement, in rotation and/or translation, such as rotation of cams, linear movements of a trolley, opening of a shelter.

In its most essential form, the proximity switch will comprise a casing which will house thereinto switching means suitable to be switched upon the operation of a drive head connected to the casing following the movement of the movable part of the machine which the switch is associated to.

The switching means are in turn operationally connected to one or more electrical and/or electronic circuits for the power supply and/or control of the main circuit and/or service and emergency circuits of the machine or plant, always in a known manner.

The switching means may be selected from those commonly used in the field and may also vary depending on the functionality of the switch, without particular limitations. The methods of connecting the switching means will be selected from those typical for this kind of product and they too will not be described in more detail below.

The casing may also house control means, for example a microprocessor or CPU, not shown, suitable for receiving input signals from the control and/or service circuits via respective communication channels to verify their correct operation.

In this way, the control means may control the switching means to send an error signal and/or to stop the machine or plant in case of absence of a communication signal from one of the communication channels or in case of detection of non-compliances.

Possibly, the casing may also be associated with a head which will be designed so as to interact with an actuator device integral with a mobile guard to allow the detection of the opening or closing of the guard itself, according to known methods not described hereinafter, as not being part of the invention.

The head may be monolithic with the casing or represent a distinct module applied to the casing, possibly removable and/or orientable according to two or more positions rotated with respect to the main development axis of the casing.

In the same way, the casing may also be associated with further auxiliary modules, such as switch reset, release and/or connection modules or modules with other functions, according to typical schemes for this kind of switches.

The casing may also house means for blocking the actuator device, i.e. means which will prevent the actuator device from separating from the switching device in the absence of a specific command and/or which will cause the total or partial blocking of the machine or plant following an opening of the access that causes separation between the two devices.

The blocking means may also be designed according to any known scheme and therefore will not be described here in more detail.

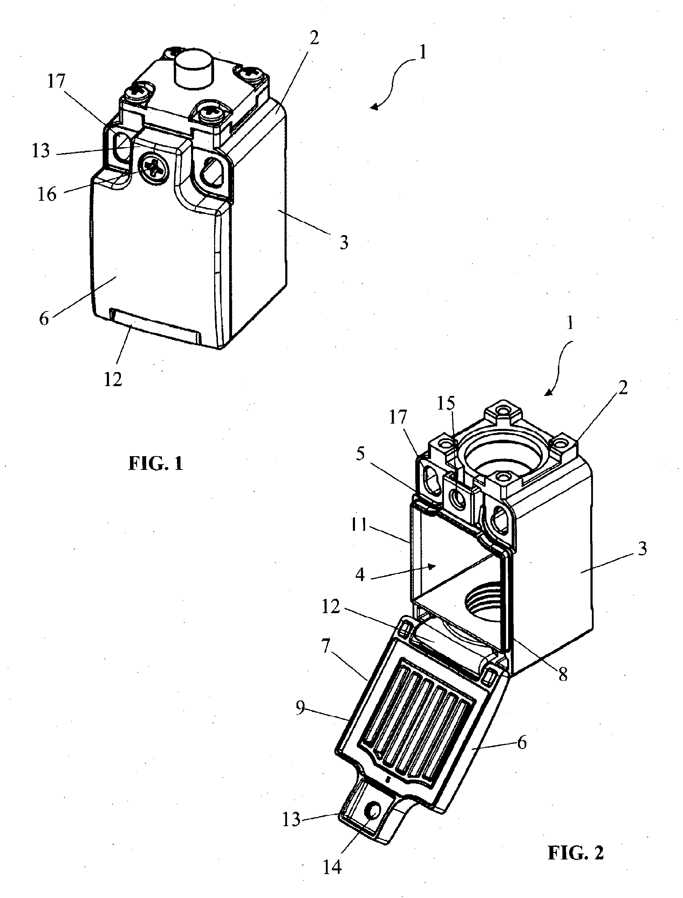

**Fig. 1** shows a first embodiment of a casing designed for the creation of the switching device of the above safety switch.

The casing, indicated overall with **1**, essentially comprises a containment shell **2** which will preferably but not exclusively be made predominantly of rigid plastic material. The containment shell **2** is provided with an opening **4** on its front face **5** to allow access thereinside.

The front face **5** may be closed by means of a lid **6** movably anchored thereto in order to be at least partially removed and move between the closed configuration of **Fig. 1** and the open one shown in **Fig. 2****.**

From this last figure, it can be observed that the lid **6** has a perimeter edge **7** designed to at least partially overlap the outer perimeter edge **8** of the opening **4** along the transverse direction and has on its inner face a groove **9** which extends along its whole perimeter edge **7**, internally thereto.

A gasket **10** made of rubber or other yielding plastic or elastomeric material will be suitably housed in the groove **9.**

The front face **5** has a raised sealing edge **11** which develops internally along the entire length of its external perimeter edge **8** with a profile corresponding to that of the groove **9.**

in summary, the raised sealing edge **11** will have a plan shape substantially corresponding to that of the groove **9.**

In this way, when closing the lid **6,** the raised sealing edge **11** will engage the whole gasket **10** and will cooperate with it to guarantee high resistance to dust and/or humidity.

The cover **6** is hinged to the front face **5** at a lower side thereof.

Preferably, the cover **6** is hinged near the lower side of the outer perimeter edge **8** of the opening **4,** external to the latter.

Furthermore, the containment shell **2** may comprise a hinge **12** which extends below the sealing edge **11** and which is designed to allow the rotatable anchoring of the lid **6,** allowing to have a raised sealing edge **11** which extends along the whole development of the outer perimeter edge **8** always with a height **h** sufficient to guarantee a high seal with the gasket **10.**

Preferably, the sealing edge **11** will develop along the whole length of the outer perimeter edge **8** without interruption.

In particular, the hinge **12** will be arranged externally to the sealing edge **11**, with respect to the opening **4,** at a distance **D** therefrom comprised interval between 2mm and 15 mm.

The hinge **12** may have a specific shape, for example shaped like a step, designed to allow the lid **6**, once anchored, to remain hinged without detaching.

However, it is understood that a different method of anchoring of the lid 6 may also be possible which; for example, the lid **6** may be hinged laterally or may be completely removable to be fixed by screws and/or by interlocking and/or by similar means.

In the illustrated embodiments, the fixing of the lid **6** will be carried out by an upper fixing flange **13** present on the lid **6** and which extends from the side opposite to the hinge **12** and which is provided with a first central through hole **14** suitable for being aligned, at the closing of the lid **6,** with a second hole **15** made on the front face **5,** above the sealing edge **11,** and arranged on a symmetry plane of the containment shell **2.**

In this way, the stable but removable fixing of the lid 6 on the containment shell **2** will be obtained solely by inserting a screw or fastening element **16** inside the two respectively aligned holes **14,15.**

However, it is understood that both the lid **6** and the containment shell **2** may each be provided with two or more mutually aligned holes for reciprocally fixing using two or more screws, or a fixing without screws can be provided, such as an interlocking fixing or the like.

The containment shell **2** is also provided with further passages **17** for the insertion of screws, not illustrated, for its anchoring to the panel or frame.

The sealing edge **11** will have a height **h** of constant value along its whole length and whose value will be at least double, preferably at least equal to 3 to 5 times, the value of its width **w.**

In the illustrated embodiments, height **h** is the size of the sealing edge **11** measured along a straight line orthogonal to the plane defined by the opening **4,** while the width **w** is the size of the sealing edge **11** measured along a straight line parallel to the plane defined by the same opening **4.**

Generally speaking, as in the case in which the plane of the opening **4** is inclined with respect to the longitudinal development of the containment shell **2,** height **h** will indicate the dimension measured along the direction of axial compression of the gasket **10.**

Furthermore, the sealing edge **11** will have a cross section of variable height with an inner portion having a height equal to the maximum value of the height **h** and joined to an outer portion having a height **h'** with a value at least equal to, preferably at least double, the maximum value of the width **w** of the sealing edge **11.**

According to a preferred but not exclusive embodiment, the sealing edge **11** will have a height **h** of a minimum value of at least 1.5mm along its whole development.

This value will be particularly advantageous as it will allow the gasket **10** to be effectively compressed in the direction of the thickness of the latter and therefore obtain an enclosure with IP69K protection rating, i.e. the maximum degree of protection against the penetration of dust and water according to the IEC 60529 classification system.

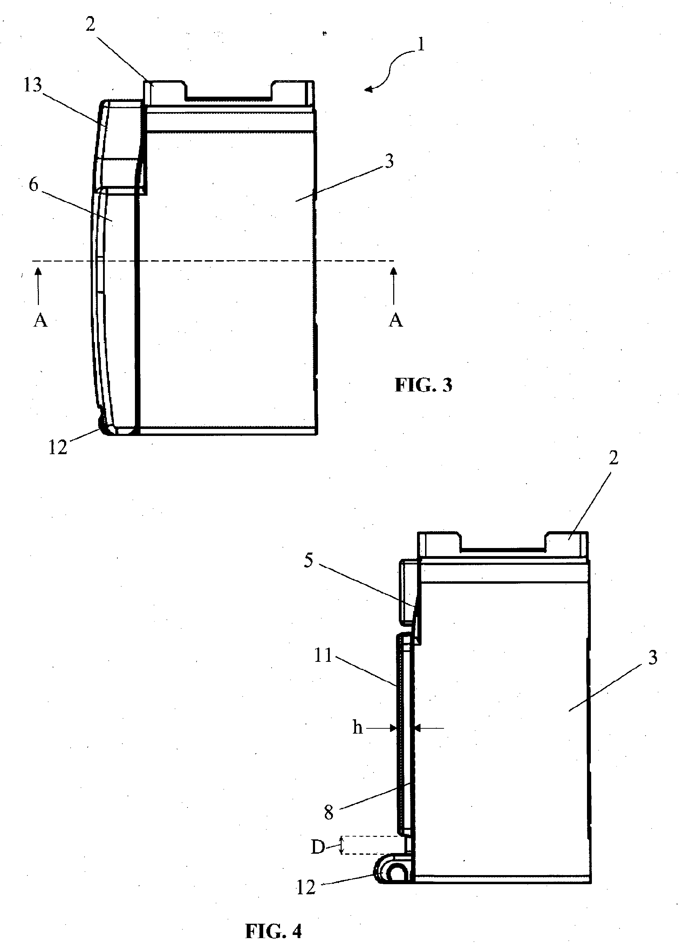

Consequently, the groove **9** will also have a depth at least equal to the height **h** of the sealing edge **11,** so that the sealing edge **11** may fit completely inside the groove **9** to compress the gasket **10** and guarantee a large surface of contact between sealing edge **11** and gasket **10** which will guarantee the aforementioned high degree of protection. From **Fig. 3** it can be seen that the lid **6** will be slightly curved towards the outside, thanks also to the possibility of having greater heights, although it can also be made flat.

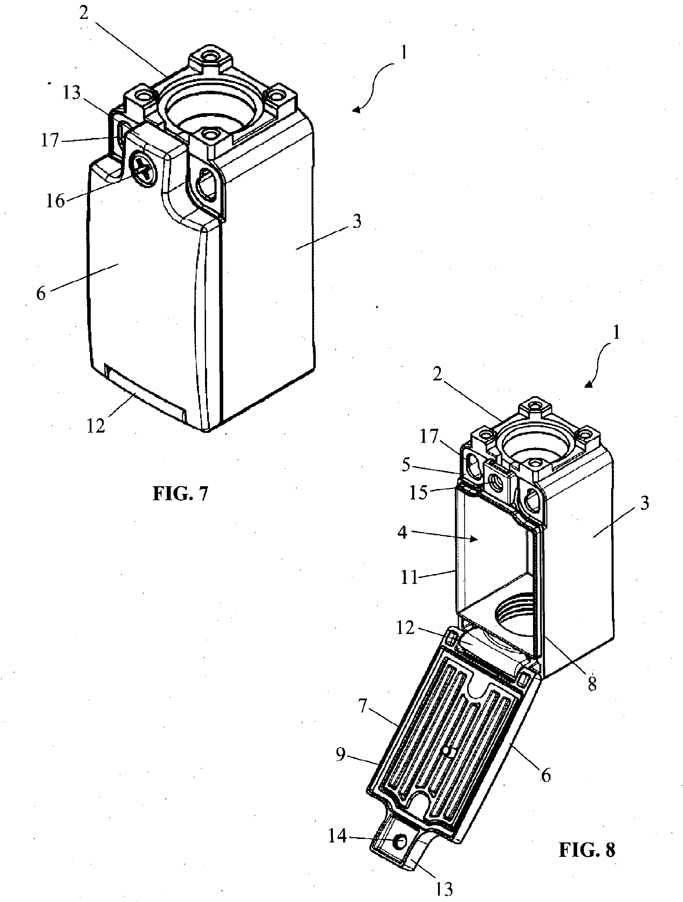

**Fig. 7** shows a second embodiment of the casing **1** which differs from the previous one essentially due to the greater length of the containment shell **2** and the lid **6.**

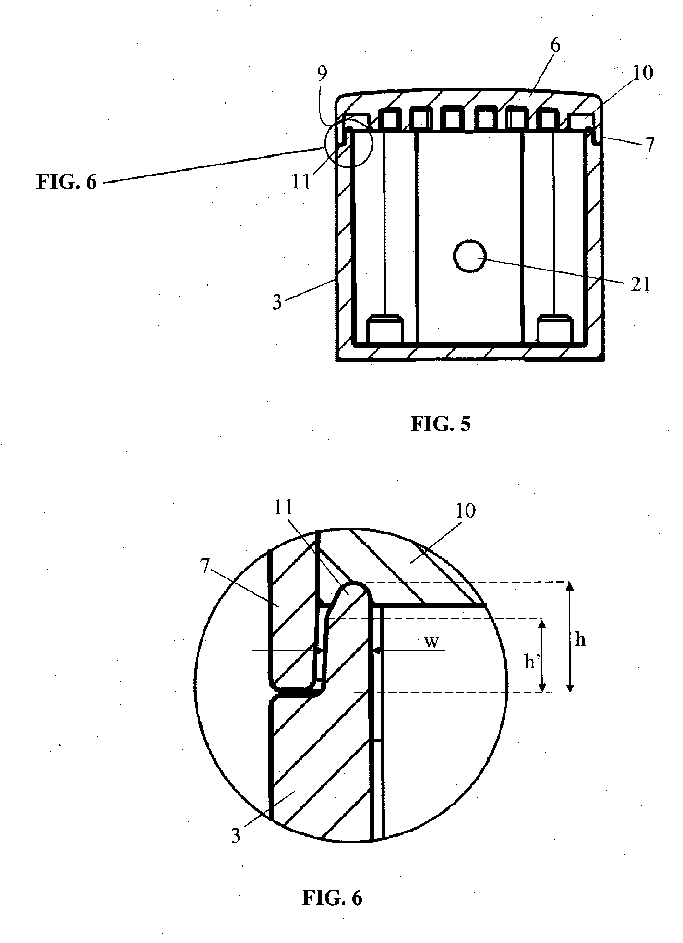

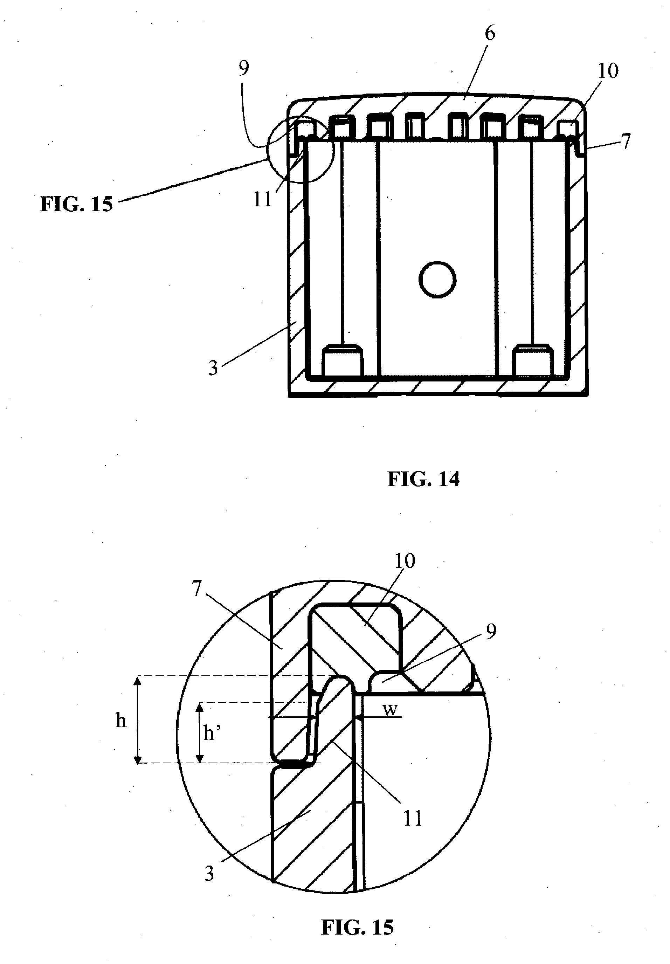

Furthermore, from the comparison between **Figs. 6** and **15** a different configuration of the gaskets **10** is also observed.

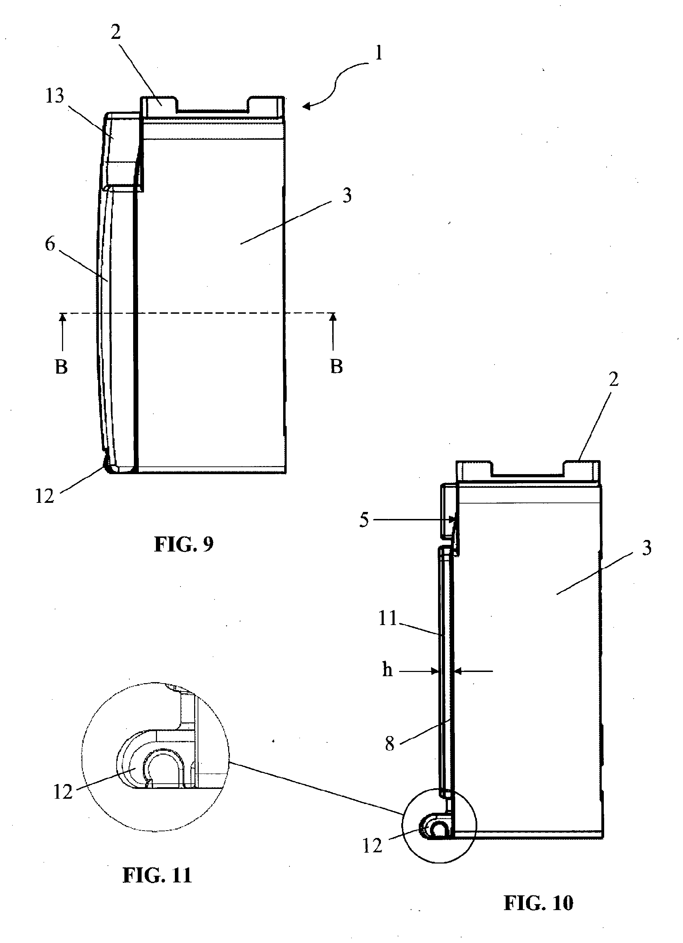

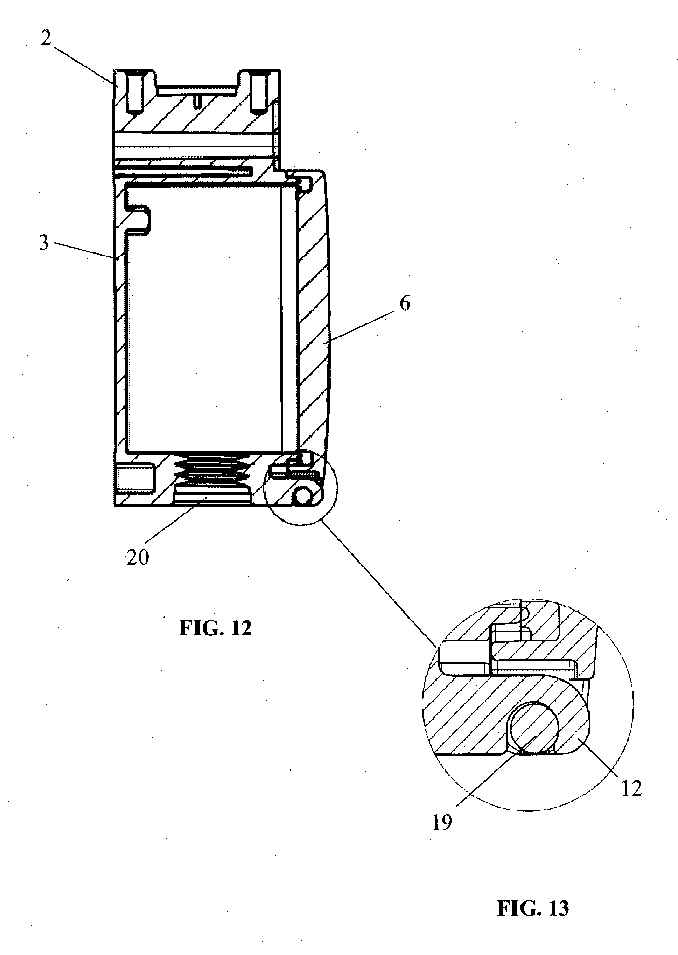

**Figs. 11** and **13** shows in greater detail the hinge coupling between the lid 6 and the containment shell **2,** with the latter provided with the hinge **12** shaped like a step to allow the insertion and snap hooking of a pin **19** of the lid **6.** .

**Figs.** from **16 to 21** shows a third embodiment of the casing **1** which differs from the previous ones in the size of the containment shell **2** and the lid **6 and** also for the sealing edge **11** that has a groove **18** which extends for part of the development of the sealing edge **11** and which is designed to house the perimeter edge **7** of the lid **6.**

Regardless of the configuration adopted, the casing **1** may be used for the assembly of safety or proximity switches of any known type and will be designed to house thereinside one or more movable contacts and/or one or more pairs of mutually movable contacts, not shown, for the opening/closing of one or more power and/or service circuits as a function of the interaction of the switch including the casing **1** with an external actuator or with a fixed or movable part of the machine or system served.

To this end, the casing **1** will be provided with at least one input hole **20** for the electrical connection of the one or more contacts, possibly threaded as visible from **Fig. 12****.**

In a known manner, the casing **1** will also be designed to allow the interaction of a mechanical, electromechanical or electronically operated mechanism or kinematics with the contacts present thereinside to promote its movement between at least one opening position and at least one closing position.

For example, the casing **1** may be associated in a stable or even removable manner with one or more modules, possibly even interchangeable with each other, provided with specific actuators having a pusher suitable of being inserted at least partially into the casing **1** through a specific passage **21,** as for the example shown in **Fig. 5****,** to operate the electrical contacts.

It is understood that the casing according to the present invention may be used to configure a safety or proximity switch according to any known or unknown type, without particular limitations.

## Claims

1. A casing for switches for industrial machine or plant control, comprising:
- a containment shell (**2**) having at least one opening (**4**) made on its front face (**5**) for accessing thereinside and having an outer perimeter edge (**8**);
- a lid (**6**) anchored in a movable manner to said front face (**5**) provided with said opening (**4**) and having a perimeter edge (**7**) adapted to at least partially overlap the outer perimeter edge (**8**) of said opening (**4**);
wherein said lid (**6**) has on its inner face a groove (**9**) which extends along the whole perimeter edge (**7**) thereof, internally thereto;
wherein a gasket (**10**) is housed in said groove (**9**);
**characterized in that** said front face (**5**) has a raised sealing edge (**11**) which extends internally to said outer perimeter edge (**8**) and along the whole longitudinal extension of said outer perimeter edge (**8**), said raised sealing edge (**11**) having a profile corresponding to that of said groove (**9**).

2. Casing as claimed in claim 1, **characterized in that** said lid (**6**) is hinged to said front face (**5**) at one side of said outer perimeter edge (**8**).

3. Casing as claimed in claim 2, **characterized in that** said lid (**6**) is hinged at the lower side of said front face (**5**),

4. Casing as claimed in claim 3, **characterized in that** said containment shell (**2**) comprises a hinge (**12**) which extends externally to said sealing edge (**11**), with respect to said opening (**4**), and is adapted to allow the movable anchoring of said lid (**6**).

5. Casing as claimed in claim 3 or 4, **characterized in that** said hinge (**12**) is provided with a shape for the stable attachment of said lid (**6**).

6. Casing as claimed in claim 4 or 5, **characterized in that** said sealing edge (**11**) is placed at a distance (**D**) from said hinge (**12**) between 2 and 15 mm.

7. Casing as claimed in any claim 4 to 6, **characterized in that** said cover (**6**) has an upper fixing flange (**13**) which extends from the side opposite to said hinge (**12**) and is provided with at least one first central through hole (**14**) adapted to be aligned, at the closure of said lid (**6**), with at least a second hole (**15**) present on said front face (**5**), externally to said outer perimeter edge (**8**), for the insertion of at least one respective screw or fixing element (**16**).

8. Casing as claimed in claim 7, **characterized in that** said at least one second hole (**15**) is arranged on a symmetry plane of said containment shell (**2**).

9. Casing as claimed in claim 7 or 8, **characterized in that** the stable and removable fixing of said lid (**6**) on said containment shell (**2**) is obtained solely by means of said screw or fastening element.

10. Casing as claimed in any preceding claim, **characterized in that** said sealing edge (**11**) has a minimum height (**h**) of at least 1.5mm along its entire length.

11. Casing as claimed in claim 10, **characterized in that** said height (h) of said sealing edge (**11**) has a value in a ratio greater than 2:1 with respect to the maximum value of its width (**w**).

12. Casing as claimed in claim 10 or 11, **characterized in that** said sealing edge (**11**) has a cross section of variable height with an inner portion having a height equal to the maximum value of said height (**h**) and connected to an outer portion having height (**h1**) at least equal to the value of the width (**w**) of said sealing edge (**11**).

13. Casing as claimed in any preceding claim, **characterized in that** said gasket (**10**) is designed to deform by compression mainly in the direction of development in height (**h**) of said sealing edge (**11**).

14. Casing as claimed in any preceding claim, for the realization of a switch provided with one or more pairs of mutually movable electric contacts and a module provided with a mechanism for activating said electric contacts having a pusher adapted to promote the movement of said electrical contacts between at least one open position and at least one closed position, **characterized in that** said containment shell (**2**) is provided with at least one inlet hole (**20**) for the electrical connection of one or more electrical contacts housed thereinside and at least one passage (**21**) for at least partial insertion of the pusher.

15. A switch for controlling industrial machines or plants, comprising:
- a casing (**1**) adapted to be anchored to a fixed or movable part of an industrial machine or plant;
- switching means housed in said casing (**1**) and adapted to be operatively connected to one or more electrical and/or electronic circuits for powering and/or controlling the main circuit and/or service and emergency circuits of the machine or plant;
wherein said casing (**1**) comprises:
- a containment shell (**2**) having at least one opening (**4**) on a front face (**5**) for accessing thereinside;
- a lid (**6**) movably anchored to said front face (**5**) and having a perimeter edge (**7**) adapted to overlap at least partially the outer perimeter edge (**8**) of said opening (**4**); wherein said lid (**6**) has on its inner face a groove (**9**) which extends for all the extension of its perimeter edge (**7**), internally thereto;
wherein a gasket (**10**) is housed in said groove (**9**);
**characterized in that** said open front face (**5**) of said side wall (**3**) has a raised sealing edge (**11**) which extends internally to said outer perimeter edge (**8**) and along the whole longitudinal extension of said outer perimeter edge (**8**), said raised sealing edge (**11**) having a profile corresponding to that of said groove (**9**).
